# EUROPEAN PATENT APPLICATION

(11) **EP 2 498 295 A1**
(43) Date of publication of application: **12.09.2012**
(21) Application number: 12158842.0
(22) Date of filing: 09.03.2012
(51) Int. Cl.: H01L 29/786, H01L 21/20, H01L 21/762, H01L 29/66

(54) **Method for forming a Ge on III/V-On-Insulator structure**

(30) Priority: 09.03.2011 FR 1151939
(71) Applicant: Soitec, 38190 Bernin (FR)
(72) Inventor: Duval, Nicolas, PLEASANTVILLE, NY 10570 (US); Aulnette, Cécile, GUILDERLAND, NY 12084 (US); Nguyen, Bich-Yen, Austin, TX 78733 (US)
(74) Representative: Collin, Jérôme

(57) **Abstract**

The present invention concerns a method for forming a Semiconductor-On-Insulator structure (10) that includes a semiconductor layer (3) of III/V material, **characterized in that** it comprises the steps of:
(a) growing a relaxed germanium layer (2) on a donor substrate (1);
(b) growing at least one layer (3) of III/V material on the layer of germanium (2);
(c) forming a cleaving plane (6) in the relaxed germanium layer (2);
(d) transferring a cleaved part of the donor substrate (1) to a support substrate (4), the cleaved part being a part of the donor substrate (1) cleaved at the cleaving plane (6) that comprises the at least one layer (3) of III/V material.

The present invention also concerns a Ge on III/V-On-Insulator structure, a NFET transistor, a method for manufacturing a NFET transistor, a PFET transistor, and a method for manufacturing a PFET transistor.

## Description

### FIELD OF THE INVENTION

The field of this invention is that of Semiconductor On Insulator (SeOI) structures enabling the formation of high-mobility channel transistors.

More precisely, the invention relates to an improved method for making such structures.

### BACKGROUND OF THE INVENTION

During the past forty years, microelectronic technology has been able to shrink the dimensions of its basic element, namely the transistor, and thus to increase the density of transistors in circuits, as well as to improve the performance of each transistor. This increase is found to follow a very well known exponential curve called "Moore's law". For the first part of this curve, the performance increase was directly derived from the smaller dimensions of the transistor, but for the last ten years, high-performance silicon-based CMOS ("Complementary Metal-Oxide Semiconductor") technology has relied heavily on materials innovations at the transistor level to maintain generational performance trends.

One aspect of the material innovations was to increase the strain in the silicon crystal to boost carrier mobility and thus to reach high current density, which directly transfer in higher performance for the circuit. This aspect has been pushed to its limits for the last generations, so now it is either inconceivable to continue to build more strain or the mobility increase saturates even if more strain is applied. However the need to gain more performance through carrier mobility gain is still present.

Field-effect type transistors rely on an electric field to control the shape and hence the conductivity of a channel of one type of charge carrier in a semiconductor material. New high-mobility materials are expected to replace silicon in the channels of such transistors. The most studied high-mobility materials for NFET ("N Field-Effect Transistor") are III/V materials, and in particular GaAs and InGaAs. Pure Ge or SiGe alloys are usually contemplated for PFET ("P Field-Effect Transistor").

However, manufacturing structures comprising such new materials, in particular Semiconductor On Insulator (SeOI) structures, remains problematic.

SeOI structures comprise one of more thin layers of semiconductor materials on a buried insulating layer, covering a support substrate, generally made of silicon. But, silicon on the first hand and GaAs or InGaAs on the other hand are crystalline materials having very different lattice parameters which cannot easily match. A layer of InGaAs grown on a silicon substrate therefore presents crystal defects, misfit and dislocations which drastically reduce performances, unless a very thick buffer layer is grown from a silicon substrate to accommodate for the large difference in lattice parameter, which is time consuming and expensive.

More compatible support substrates exist, for example made of GaAs or InP, but such alternative substrates are expensive and present a limited diameter (150 mm InP wafers to compare with 300 mm silicon wafers).

All of these solutions are unadpated with high yield microelectronic manufacturing.

Moreover, moving away from silicon to high-mobility materials implies to have two different SeOI structures for N and P-FETs, whereas silicon enables both.

Finally, there is another major obstacle to form a conventional III/V transistor with implanted source and drain. Indeed, a transistor needs three electrodes, two of then being connection points with the semiconductor material in a FET (at the source and the drain). But, due to doping implantation defects that are impossible to heal, metallic contacts with III/V materials present a high resistance, which also reduces performance.

For all these reasons, the silicon has remained the preferred material for the time-being.

There is consequently a need for a method for forming a SeOI structure enabling a high yield manufacturing of a III/V high-mobility channel transistor, with low access resistance source and drain contacts.

### SUMMARY OF THE INVENTION

For these purposes, the present invention provides a method for forming a Semiconductor-On-Insulator structure that includes a semiconductor layer of III/V material, **characterized in that** it comprises the steps of:
(a) growing a relaxed germanium layer on a donor substrate;
(b) growing at least one layer of III/V material on the layer of germanium;
(c) forming a cleaving plane in the relaxed germanium layer;
(d) transferring a cleaved part of the donor substrate to a support substrate, the cleaved part being a part of the donor substrate cleaved at the cleaving plane that comprises the at least one layer of III/V material.

As the structure is realized from silicon support substrates, industrial 300 mm wafers can be manufactured. High yield, low cost production is possible.

Moreover, the Ge layer can be used to form low-resistance contacts, as Ge-III/V heterojunction is known as being of the non-Schottky type (no potential barrier appears at the junction). Source and drain are then implanted in the Ge layer.

Preferred but non limiting features of the present invention are as follow:
- the III/V material is InGaAs;
- the donor substrate is made of silicon;
- step (a) of growing a relaxed germanium layer comprises a previous sub-step (a1) of growing a silicon germanide buffer layer of lattice adaptation on the donor substrate, the relaxed germanium layer being grown on the silicon germanide buffer layer;
- step (c) of forming a cleaving plane in the relaxed germanium layer comprises a previous sub-step (c1) of forming an insulating layer on the least one layer of III/V material and/or on the support substrate;
- step (c1) of forming an insulating layer comprises a thermal oxidation of the support substrate;
- step (c1) of forming an insulating layer comprises a deposition of an oxide layer on the at least one layer of III/V material;
- step (b) of growing at least one layer of III/V material on the layer of germanium comprises a following sub-step (b1) of forming a thin silicon layer on the at least one layer of III/V material;
- the support substrate is a Silicon-On-Insulator structure comprising an insulating layer.

In a second aspect, the invention provides a Ge on III/V-On-Insulator structure comprising a support substrate, an insulating layer, an at least one layer of III/V material on the insulating layer, a germanium layer on the at least one layer of III/V material.

Furthermore, the Ge on III/V-On-Insulator structure as formed according to the invention enable the manufacturing of both NFET and PFET transistors.

In a third aspect, the invention provides a NFET transistor formed in a Ge on III/V-On-Insulator structure according to the second aspect of the invention, the NFET transistor comprising
a gate in a cavity in the germanium layer down to the III/V material layer, the gate being insulated from the germanium layer and the III/V layer by a high-K dielectric material;
a source region in the germanium layer on a first side of the cavity; and
a drain region in the germanium layer on a the other side of the cavity.

In a fourth aspect, the invention provides a method for manufacturing a NFET transistor according to the third aspect of the invention, comprising the steps of:
- forming a Ge on III/V-On-Insulator structure according to the second aspect of the invention;
- forming a cavity in the germanium layer down to the III/V material layer;
- depositing in the cavity a high-K dielectric material and a gate, the gate being insulated from the germanium layer and the III/V layer by the high-K dielectric material;
- implanting a source region and a drain region in the germanium layer on each side of the cavity.

In a fifth aspect, the invention provides a PFET transistor formed in a Ge on III/V-On-Insulator structure according to the second aspect of the invention, the NFET transistor comprising
an island on the germanium layer, the island comprising a gate insulated from the germanium layer by a high-K dielectric material;
a source region in the germanium layer on a first side of the island; and
a drain region in the germanium layer on a the other side of the island.

In a sixth aspect, the invention provides a method for manufacturing a PFET transistor according to the fifth aspect of the invention, comprising the steps of:
- forming a Ge on III/V-On-Insulator structure according to the second aspect of the invention,
- forming a island on the germanium layer by deposing a high-K dielectric material and a gate, the gate being insulated from the germanium layer by the high-K dielectric material;
- implanting a source region and a drain region in the germanium layer on each side of the island.

Preferred but non limiting features of the present invention are as follow:
- the Ge on III/V-On-Insulator structure is formed according to the first aspect of the invention, the method comprises a step of forming a cavity in the buffer layer down to the germanium layer before the step of forming the island, the gate being insulated from the buffer layer by the high-K dielectric material;
- the germanium layer is partially recessed before the step of forming the island.

### BRIEF DESCRIPTION OF THE DRAWINGS

The above and other objects, features and advantages of this invention will be apparent in the following detailed description of an illustrative embodiment thereof, with is to be read in connection with the accompanying drawings wherein:
- Figure 1 represents steps of a embodiment of a method according to the first aspect of the invention;
- Figure 2 represents steps of another embodiment of a method according to the first aspect of the invention;
- Figure 3 is a transversal view of a NFET transistor manufactured by an embodiment of a method according to the second aspect of the invention;
- Figure 4 is a transversal view of an embodiment of a PFET transistor manufactured by an embodiment of a method according to the third aspect of the invention.

### DETAILED DESCRIPTION OF A PREFERRED EMBODIMENT

### III/V layer on Si/Ge donor

Referring to the drawings, a method according to a possible embodiment of the invention will now be described.

The invention proposes to intercalate a layer of relaxed germanium 2 between a donor substrate 1, advantageously made of silicon, and at least one layer 3 of III/V material, the III/V material being for example InP, AsGa, InAs and advantageously InAsGa, because of its charge carrier high mobility. Indeed, lattices of Ge and III/V materials are close enough to allow for the growth of a III/V material layer on top of the relaxed Ge layer without lattice accommodation issue. Moreover, methods for growing a relaxed Ge layer on top of a bare silicon donor substrate are known by a man skilled in the art.

A layer is "relaxed" if its crystalline material has a lattice parameter substantially identical to its nominal lattice parameter, wherein the lattice parameter of the material is in its equilibrium form without stress applied on it. Conversely, a layer is "strained" if its crystalline material is elastically stressed in tension on in compression. For example, a strained layer can be obtained by epitaxial growth of one material onto a second material - the 2 materials having different lattice parameter.

As germanium and silicon have different lattice parameter, a first method for growing a relaxed Ge layer on top of a silicon substrate is to grow a layer of lattice adaptation, made of germanium strained at its base (this thin Ge layer will have the same in-plane lattice parameter as silicon, therefore highly strained due to the 4% mismatch between the lattice parameter) and gradually relaxed while the layer thickens. From a sufficient thickness, the germanium growing is totally relaxed. That technique usually requires an at least 2µm thick Ge layer.

Alternatively, a silicon germanide buffer layer 7 of lattice adaptation is used. This buffer layer 7 is grown on the silicon donor substrate 1 before growing the relaxed germanium layer, and is made of relaxed SiGe, with an increasing proportion of germanium while the buffer layer 7 thickens. Thus, at its interface between the silicon donor substrate 1, the buffer layer 7 is essentially made of silicon, and at its interface with the relaxed germanium layer 2, the buffer layer 7 comprises a sufficient proportion of germanium for enabling the growth of pure relaxed germanium without lattice adaptation issues. This technique usually requires a buffer layer 7 of 2 to 5 microns thick.

Alternatively, the whole donor substrate may be made of SiGe, and acts as a lattice adaptation layer. The relaxed germanium can be directly grown on this SiGe substrate.

### Formation of a SeOI structure

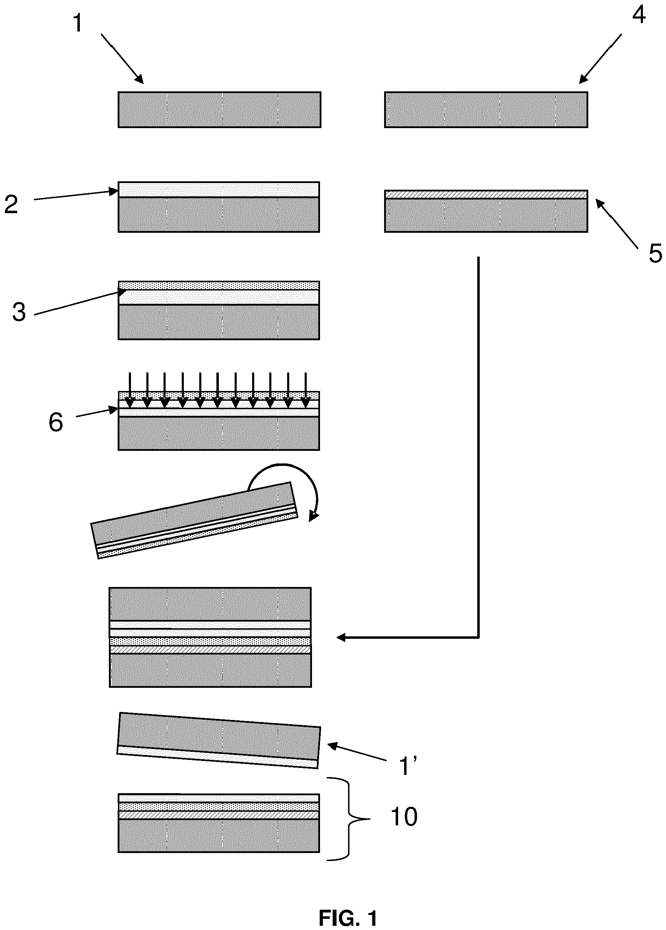

Steps of an embodiment of the method for forming a semiconductor-on-insulator structure 10 that includes a semiconductor layer 3 of III/V material according to the invention are represented by the figure 1.

The relaxed germanium layer 2 is grown on the donor substrate 1, as explained previously. Then at least one layer 3 of a III/V material, advantageously a layer of InAsGa, is grown on the germanium layer 2.

A support substrate 4 is also prepared, said support substrate 4 being advantageously made of silicon, or any other materials typically used for substrates. The support substrate 4 may be a standard Silicon-On-Insulator substrate, comprising an insulating layer 5 under a thin silicon layer 8.

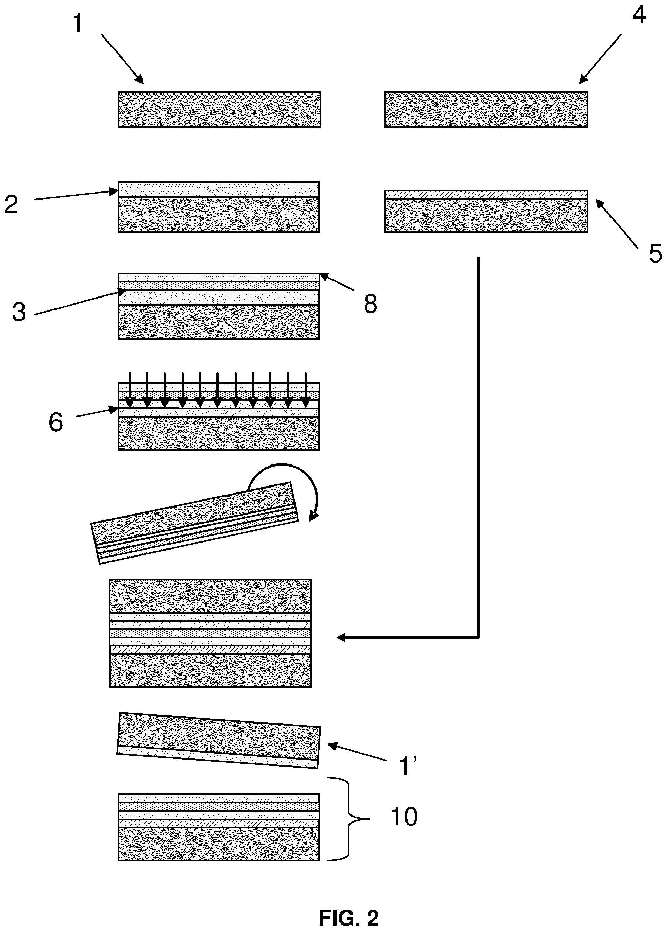

If the support substrate 4 is not a Silicon-On-Insulator structure, in other words if the support substrate 4 does not comprises an insulating layer 5, the insulating layer 5 is advantageously formed on the at least layer 3 of III/V material and/or on the support substrate 4. In the embodiment represented by the figure 1, the insulating layer is formed by a thermal oxidation of the support substrate 4. For example, if the support substrate 4 is made of silicon, a silicon dioxide insulating layer is formed. Alternatively, the insulting layer 5 can be deposited, in particular on the III/V material layer 3. Oxides are also preferred. Advantageously, an oxide layer is formed or deposited on both surfaces. Indeed, a oxide/oxide bonding is known to be of good quality. Alternatively, it is also possible to form a thin silicon layer 8 on the III/V material layer 3 prior to the formation of the at least one insulating layer 5, thus a Silicon-On-Insulator understructure is reconstituted when donor and support substrates 1, 4 are bonded. This embodiment is represented by figure 2.

A cleaving plane 6 is then formed in the relaxed germanium layer 2. It can be noted that this step could be performed before the step of forming an insulating layer 5, or even simultaneously if the insulating layer 5 is formed only on the support substrate 4. To this end, the relaxed germanium layer 3 is for example implanted according to the Smart-Cut™ technology with ionic species like hydrogen. The implantation leads to the creation of the cleaving plane 6 which is a buried, weakened zone. Further, the donor substrate 1 is bonded with the support substrate 4 and then separated by cleaving the source substrate 1 at a depth corresponding to the penetration depth of the implanted species (the cleaving plane 6), i.e. in the germanium layer 6. Advantageously, if the germanium layer has been grown on a silicon germanide buffer layer 7, the cleaving plane can be formed in this sub-layer 7.

In this way, a SeOI structure 10 (and more precisely a Ge on III/V-On-Insulator structure) is obtained, it contains the support substrate 4 and a cleaved part of the donor substrate 1 that comprises the at least one layer 3 of III/V material and a residue of the germanium layer 2 (or if applicable the germanium layer 2 and a residue of the germanide buffer layer 7). A remaining delaminated substrate 1' being part of the former source substrate 1, possibly topped by a residue of the germanium layer 2 (or if applicable a residue of the germanide buffer layer 7) is also produced.

As for the bonding, it is possible with or without activation (in particular in the case of a oxide/oxide contact), but the preferred option is CMP (Chemical-Mechanical Polishing) activation bonding.

### Ge on III/V-On-Insulator structure

According to a second aspect of the invention, a Ge on III/V-On-Insulator structure is provided, this structure being formed thanks to a method for forming a SeOI structure 10 as previously described.

The Ge on III/V-On-Insulator structure 10 comprises a support substrate 4, an insulating layer 5, an at least one layer 3 of III/V material on the insulating layer 5, a germanium layer 2 on the at least one layer 3 of III/V material.

In an especially advantageous way, the structure 10 finally comprises from the bottom to the top:
- a silicon substrate 4,
- a silicon oxide insulating layer 5,
- possibly a thin silicon layer 8,
- a InAsGa layer 3,
- a relaxed Ge layer 2,
- a residual germanide buffer layer 7.

### NFET Transistor

According to a third aspect and a fourth aspect of the invention, a NFET transistor 20a manufactured from a Ge on III/V-On-Insulator structure 10 as previously described and a method for manufacturing such a NFET transistor 20a are respectively provided.

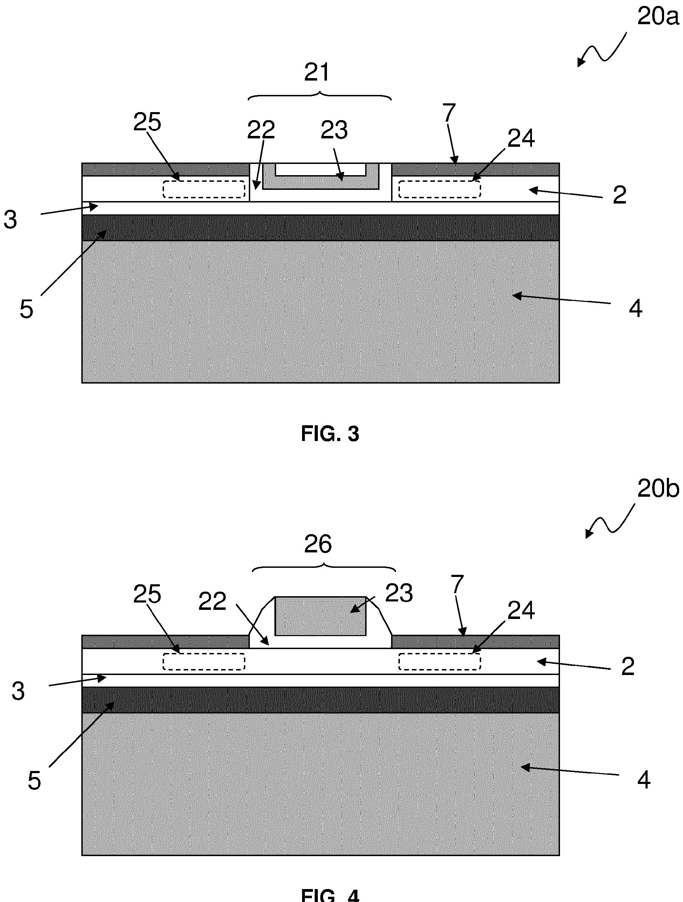

Such a high-performance NFET transistor 20a is represented by the figure 3. As already explained, field-effect type transistors rely on an electric field to control the shape and hence the conductivity of a channel of one type of charge carrier in a semiconductor material. In the N-type (negative), the charge carriers are the electrons. So, the semiconductor is P-doped (or undoped if operated under Fully Depleted conditions), and when activated a N-channel forms and current can circulate.

To manufacture such a NFET transistor 20a, the Ge on III/V-On-Insulator structure 10 is formed in a first step. Then a cavity 21 is formed in the germanium layer 2 down to the III/V material layer 3.. By this cavity 21, the germanium layer 2 is separated into two parts only linked by the InAsGa layer 3 typically undoped for fully depleted operation mode. A layer of a high-K dielectric material 22 is then firstly deposited. The term high-K dielectric refers to a material with a high dielectric constant k (as compared to silicon dioxide): leakage currents due to tunneling must be avoided, resulting in the use of specific insulating materials. The gate 23 is then deposited, and covered with high-K dielectric material 22. The gate 23 is advantageously made of metal, and is insulated from other layers by the high-K dielectric material 22.

Finally, a source region 24 and a drain region 25 are formed by implanting in the two parts of the germanium layer 2 separated by the cavity 21. Indeed, as already explained, the Ge layer is used to form low-resistance contacts, as Ge-III/V heterojunction is known as being of the non-Schottky type. The NFET transistor is now operational. By applying a sufficient positive gate-to-source voltage (referred to as the threshold voltage of the FET), the conductive channel appears: enough electrons must be attracted near the gate to counter the dopant ions added to layer 3, it first forms a region free of mobile carriers called a depletion region. Further gate-to-source voltage increase will attract even more electrons towards the gate which are able to create the apparition of an excess of negative charges, this process is called inversion.

### PFET Transistor

According to a fifth and a sixth aspect of the invention, a PFET transistor 20b manufactured from a Ge on III/V-On-Insulator structure 10 as previously described and a method for manufacturing such a PFET transistor 20b are respectively provided.

Such a high-performance PFET transistor 20b is represented by the figure 4. In the P-type (positive), the charge carriers are the holes. So, the semiconductor is N-doped (or undoped if operated under Fully Depleted condition), and when activated a P-channel forms and current can circulate. This is a reverse functioning with respect to a NFET transistor.

To manufacture such a PFET transistor 20b, the Ge on III/V-On-Insulator structure is formed in a first step. Then an island 26 is formed on the germanium layer 2: a layer of a high-K dielectric material 22 is firstly deposited. A gate 23 is then deposited. This is preferably a metal gate. Indeed, for holes the high mobility layer is the germanium layer 2, so the germanium layer 2 is not separated into two parts. Advantageously, the germanium layer 2 is nevertheless partially recessed before forming the island. Thus, a thinner germanium channel will be easier to open. If there is a germanide layer 7, a cavity is formed in this layer down to the germanium layer 2, in order to have the island directly formed on the germanium layer 2. The gate 23 is advantageously made of metal, and is insulated from other layers by the high-K dielectric material 22.

Finally, a source region 24 and a drain region 25 are formed by implanting in the two parts of the germanium layer 2 on each side of the island 26. The PFET transistor is now operational. Similarly to the NFET, by applying a sufficient positive gate-to-source voltage, the conductive channel appears: enough holes must be attracted from the InAsGa layer 3 to the germanium layer 2 to counter the dopant ions added.

## Claims

1. A method for forming a Semiconductor-On-Insulator structure (10) that includes a semiconductor layer (3) of III/V material, **characterized in that** it comprises the steps of:
(a) growing a relaxed germanium layer (2) on a donor substrate (1);
(b) growing at least one layer (3) of III/V material on the layer of germanium (2);
(c) forming a cleaving plane (6) in the relaxed germanium layer (2);
(d) transferring a cleaved part of the donor substrate (1) to a support substrate (4), the cleaved part being a part of the donor substrate (1) cleaved at the cleaving plane (6) that comprises the at least one layer (3) of III/V material.

2. A method according to claim 1, wherein the III/V material is InGaAs.

3. A method according to any one of claims 1 to 2, wherein the donor substrate (1) is made of silicon

4. A method according to claim 3, wherein step (a) of growing a relaxed germanium layer (2) comprises a previous sub-step (a1) of growing a silicon germanide buffer layer (7) of lattice adaptation on the donor substrate (1), the relaxed germanium layer (2) being grown on the silicon germanide buffer layer (7).

5. A method according to any one of claims 1 to 4, wherein step (c) of forming a cleaving plane (6) in the relaxed germanium layer (2) comprises a previous sub-step (c1) of forming an insulating layer (5) on the least one layer (3) of III/V material and/or on the support substrate (4).

6. A method according to claim 5, wherein step (c1) of forming an insulating layer (5) comprises a thermal oxidation of the support substrate (4).

7. A method according to any one of claims 5 to 6, wherein step (c1) of forming an insulating layer (5) comprises a deposition of an oxide layer on the at least one layer (3) of III/V material.

8. A method according to any one of claims 5 to 7, wherein step (b) of growing at least one layer (3) of III/V material on the layer of germanium (2) comprises a following sub-step (b1) of forming a thin silicon layer (8) on the at least one layer (3) of III/V material.

9. A method according to any one of claims 1 to 4, wherein the support substrate (4) is a Silicon-On-Insulator structure comprising an insulating layer (5).

10. A Ge on III/V-On-Insulator structure (10) comprising a support substrate (4), an insulating layer (5), an at least one layer (3) of III/V material on the insulating layer (5), a germanium layer (2) on the at least one layer (3) of III/V material.

11. A NFET transistor (20a) formed in a Ge on III/V-On-Insulator structure (10) according to claim 10, the NFET transistor (20a) comprising a gate (23) in a cavity (21) in the germanium layer (2) down to the III/V material layer (3), the gate (23) being insulated from the germanium layer (2) and the III/V layer (3) by a high-K dielectric material (22);
a source region (24) in the germanium layer (2) on a first side of the cavity (21);and
a drain region (25) in the germanium layer (2) on a the other side of the cavity (21).

12. A method for manufacturing a NFET transistor (20a) according to claim 11, comprising the steps of:
- forming a Ge on III/V-On-Insulator structure (10) according to claim 10;
- forming a cavity (21) in the germanium layer (2) down to the III/V material layer (3);
- depositing in the cavity (21) a high-K dielectric material (22) and a gate (23), the gate being insulated from the germanium layer (2) and the III/V layer (3) by the high-K dielectric material (22);
- implanting a source region (24) and a drain region (25) in the germanium layer (2) on each side of the cavity (21).

13. A PFET transistor (20b) formed in a Ge on III/V-On-Insulator structure (10) according to claim 10, the NFET transistor (20b) comprising an island (26) on the germanium layer (2), the island (26) comprising a gate (23) insulated from the germanium layer (2) by a high-K dielectric material (22);
a source region (24) in the germanium layer (2) on a first side of the island (26); and
a drain region (25) in the germanium layer (2) on a the other side of the island (26).

14. A method for manufacturing a PFET transistor (20b) according to claim 13, comprising the steps of:
- forming a Ge on III/V-On-Insulator structure (10) according to claim 10,
- forming a island (26) on the germanium layer (2) by deposing a high-K dielectric material (22) and a gate (23), the gate (23) being insulated from the germanium layer (2) by the high-K dielectric material (22);
- implanting a source region (24) and a drain region (25) in the germanium layer (2) on each side of the island (26).

15. A method according to claims 14, wherein the Ge on III/V-On-Insulator structure (10) is formed by the method of claim 4, comprising a step of forming a cavity in the buffer layer (7) down to the germanium layer (2) before the step of forming the island (26), the gate (23) being insulated from the buffer layer (7) by the high-K dielectric material (22).

16. A method according to any one of claims 14 to 15, wherein the germanium layer (2) is partially recessed before the step of forming the island (26).
